# EUROPEAN PATENT APPLICATION

(11) **EP 3 264 024 A1**
(43) Date of publication of application: **03.01.2018**
(21) Application number: 16275091.3
(22) Date of filing: 28.06.2016
(51) Int. Cl.: F42B 15/01, F42B 30/00, G06F 15/78, G06F 15/80, H05K 7/14, H05K 7/20, F42B 10/46, F42B 19/00

(54) **NOSE CONE COMPRISING ELECTRONIC CIRCUIT BOARDS ARRANGED RADIALLY**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

The invention relates to A nose cone assembly for a munition, comprising a transducer array operably linked to a transmission assembly, wherein the transducer array is operably connected to a transducer housing, said transducer housing comprising a first and second surface, wherein said transmission assembly is reversibly operably connected to the second surface of said transducer housing,
said transmission assembly comprising a control board and a plurality of electronic circuit boards, wherein at least one electronic circuit board is a transceiver circuit board,
said electronic circuit boards being reversibly connected to the control board and being arranged along their longest dimension, at an axis substantially perpendicular to the control board and further arranged such that the electronic circuit boards extend radially inwardly to a substantially rotational centre of the control board.

## Description

The invention relates to a nose cone for a munition, more specifically related to the arrangement of electronic components in the nose cone of a signal-emitting projectile, such as a missile or torpedo.

Within the field of steerable, rather than "dumb" munitions a projectile may comprise a number of sections containing various component parts to allow the munition to perform various actions required for its operation. These sections typically comprise a means of propulsion, in order to propel the projectile through the air or water, a warhead or body section, containing the main charge or other output payload and a guidance section, which may include communications for external command input. Though not a requirement, the guidance portion is often located in the nose of the projectile. Given the traditional proportions of even large projectiles, the fitting of electronics into the nose can often be difficult, due to a number of factors, all of which must be considered during the projectiles design.

A projectiles construction has to accommodate the electronics used for systems such as guidance, the power source for the components, such as the electronic e.g. battery, the payload of explosives to be used, including any initiating means, fuel and signalling equipment, whether for the emission of sonar/radar or the actual control of the projectile in motion. The design constraints may be further complicated by the requirement for undertaking maintenance, wherein engineers may be required to change components, update software or replace items in their respective areas throughout the projectile. This can often result in additional time and expense of removing component parts to get to other underlying components, as well as the dealing with difficult to manage sections of equipment, increasing the potential for human error.

The construction of a nose cone section, wherein the nose cone section comprises the guidance components for guided projectiles often requires a signal modification means, such as a transducer, a receive and transmit means as well as a method of interpreting the signals to control the rest of the projectile in order to adjust course, in the example of guidable projectiles. The projectile or nose cone section may also include a means of receiving signals from the launching platform in the field of steerable munitions. These components are often interconnected within the projectile by a large number of Printed Circuit Boards (PCBs) to process or pass the information via a series of interconnecting wires. This leads to a huge difficulty when preforming maintenance, replacing components, managing the heat produced by the various electronic devices and manufacture of the nose cone itself.

According to a first aspect of this invention there is provided a nose cone assembly for a munition, comprising a transducer array operably linked to a transmission assembly, wherein the transducer array is operably connected to a transducer housing, said transducer housing comprising a first and second surface, wherein said transmission assembly is reversibly operably connected to the second surface of said transducer housing,
said transmission assembly comprising a control board and a plurality of electronic circuit boards, wherein at least one electronic circuit board is a transceiver circuit board,
said electronic circuit boards being reversibly connected to the control board and being arranged along their longest dimension, at an axis substantially perpendicular to the control board and further arranged such that the electronic circuit boards extend radially inwardly to a substantially rotational centre of the control board.

In one arrangement the nose cone cover may comprise a cupola or frustroconical recess to allow the insertion of a transducer housing and transmission assembly. The transducer housing may comprise a transducer array, which comprises at least one transducer; preferably there is a plurality of transducers. The transducer array is responsible for the transduction between an electro-magnetic or acoustic signals, such as, for example a radar or a sonar signal to an electronic signal. In a preferred arrangement there may be a plurality of transducers each requiring electrical connection to the transmission assembly via conductors, such as, for example via through-hole conductors to the second surface.

The transducer array may be mounted the first surface of the transducer housing, and encapsulated by a protective cover.

The second surface of the transducer housing may have a number of electrical connection points to permit transfer of electronic signals between the transducer array and the electronic circuit boards (ecb) of the transmission assembly.

In a preferred arrangement the transmission assembly may be reversibly attached to the second surface of the transducer housing, such as for example, utilising a co-operative push-fit connection between each of the electronic circuit boards of the transmission assembly and the second surface of the transducer housing. The use of individual push-fit connectors allows removal of individual boards, for maintenance or repair, without removing all of the electronic circuit boards.

The electronic circuit boards may also be reversibly attached to the control board of the transmission assembly by further push-fit connectors. The control board, which may itself be a further electronic circuit board, may be used to manage the outputs and inputs to the electronic circuit boards, such as for example the transmissions between the nose cone assembly and the remainder of the munitions components where applicable.

The use of reversible connectors, such as push-fit connectors means between the ecb's and the control board and the transducer housing removes the need for fixed connection means such as wire or solder, which have to be physically broken and detached to permit replacement or testing.

The electronic circuit boards have a longest dimension, and are arranged along their longest dimension at an axis substantially perpendicular to the control board, and the electronic circuit boards are further arranged such that they extend radially inwardly to a substantially rotational centre of the control board This arrangement permits 360 degree access to any of the electronic circuit boards of the transmission assembly, which may facilitate examination in the event of failure, and allows a single electronic circuit board replacement without the need to remove any adjacent or indeed all electronic circuit boards or a multitude of functioning parts to reach a specific electronic circuit board.

In a further arrangement there may be a support hub, located at the substantially rotational centre of the control board. The support hub may provide support to both the electronic circuit boards and therefore the transmission assembly. The support hub may be of any cross section shape of material, preferably the support hub is rigid, and may comprise at least one void, such as, for example a cavity, hollow tube, or a plurality of vent apertures, throughout its length. The at least one void may allow the transfer of heat away from all electronic components such as the electronic control boards in order to assist cooling within the nose cone assembly systems by allowing the passing of a cooling fluid, preferably air. The support hub may also allow electronic connection to the edges of the electronic circuit boards.

In a further arrangement a first support ring may be located around the circumference of the electronic circuit boards. The first support ring may be positioned on the outer edges of the electronic circuit boards and affixed to the outside edges. In a preferred arrangement, the first support ring may be mounted on the control board by at least one support spoke. The support spokes may be interspersed between and orientated in a similar fashion to the electronic circuit boards. The support spokes may be constructed from a rigid material, such as for example polymers, metals, composites, and may provide support for the transmission assembly.

In a further arrangement the transducer housing may comprise a sub-frame, mounted on the second surface of the transducer housing. The sub-frame may comprise at least one support leg and a second support ring. The second support ring may receive the transmission assembly and provide the function of guiding the transmission assembly into engagement with the second surface of the transducer housing. The second support ring may protect the transmission assembly from damage caused by adverse knocks. In a preferred arrangement, during assembly, the second support ring may engage with the first support ring. This may be achieved utilising a mechanical fixing method, such as, for example, a bolt and nut arrangement, however it is more preferable that it is achieved utilising a co-operative a lug and void arrangement, where the first support ring sits inside the second support ring. The co-located first and second support rings may then be mechanically secured together.

The use of modular construction for the nose cone assembly allows the quick and simple detachment, test and reassembly of the separate component parts of the nose cone. In an example arrangement the transmission assembly may be detached from the second surface of the transducer housing and removed from the nose cone, after which individual electronic circuit boards may be unplugged and exchanged by use of the push-fit connections with the control board. After re-fitting the transmission assembly may be returned to the nose cone assembly to be reengaged with the second surface. This arrangement reduces the time, cost and complexity associated with more complex arrangements of component parts, allowing the nose cone to be returned to the munition quickly and the munitions "down-time" being significantly reduced, as well as the associated financial cost.

Whilst the invention has been described above, it extends to any inventive combination of the features set out above, or in the following description, drawings or claims.

Exemplary embodiments of the device in accordance with the invention will now be described with reference to the accompanying drawings in which:-
Figure 1 shows an assembled, modular nose cone assembly.
Figure 2 shows an example, exploded view of the modular nose cone assembly.
Figure 3 shows a detailed view of an example transmission assembly and example electronic circuit board arrangement.
Figure 4 shows a detailed view of an example transducer housing and sub-frame arrangement.

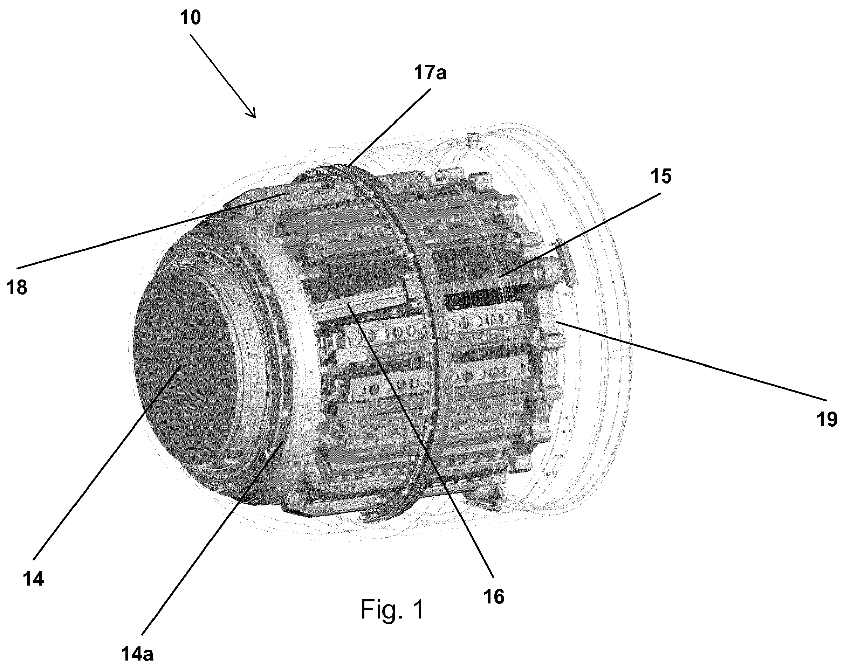

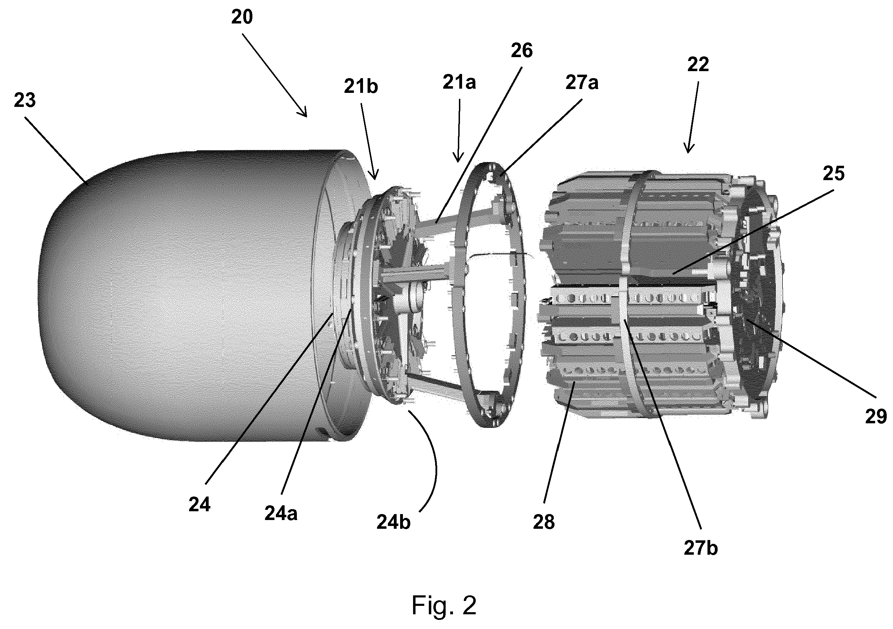

Referring to Fig 1, there is shown an assembled nose cone assembly 10 comprising a control board 19 a second support ring 17a linked with a first support ring (not shown) with said second support ring 17a comprising a support leg 16. The electronic circuit boards 18 are arranged around a support hub (not shown) with interspersed support spokes 15 linked to the control board 19, providing additional support to the transmission assembly. A first surface 14a of the transducer housing has mounted thereon the transducer array (not shown), which is protected by a cover 14. The nose cone assembly 10 is the first part to be inserted into the nose cone cover (shown in Fig 2).

Referring to Fig 2, there is shown an exploded view of the nose cone assembly 20 arrangement. The nose cone assembly 20 comprises a nose cone cover 23, a transducer housing 21 b and connected thereto a sub-frame 21 a, which is capable of housing the transmission assembly 22. In this embodiment the transducer housing 21 b, houses the transducer array (not shown), which is protected by a cover 24. The transducer array may be mounted on the first surface 24a. On the second surface 24b, of the transducer housing is located a sub-frame 21 a. The sub-frame 21 a comprises three legs 26 and a second support ring 27a for receipt of the transmission assembly 22.

The transmission assembly comprises a control board 29, to which are electrically connected a plurality of electronic circuit boards 28. The control board 29 further comprises a number of support spokes 25 which are attached to a first support ring 27b.

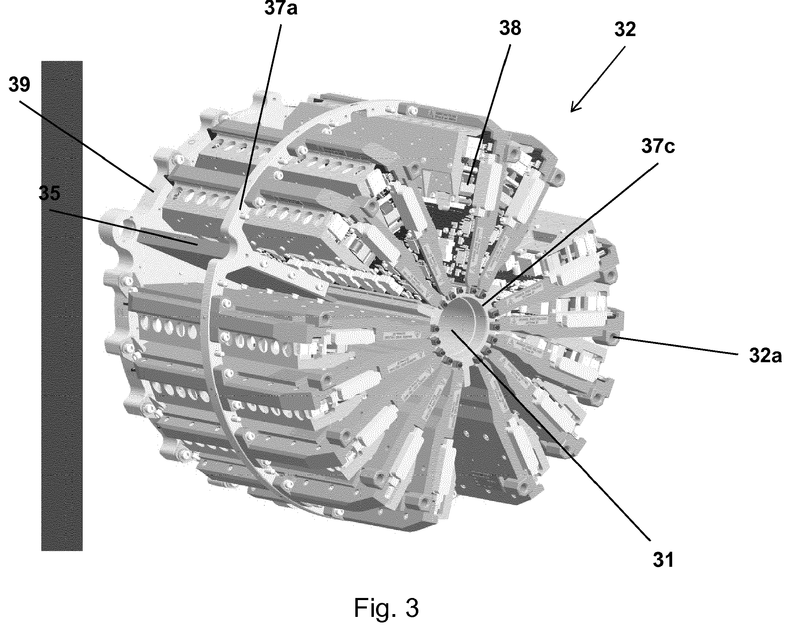

The electronic circuit boards are arranged around a support hub (not shown (see Fig 3) and are reversibly attached to the control board 29. Support spokes 25 are mounted on the control board 29 and are interspersed between certain electronic circuit boards, and attach to the first support ring 27b.

The arrangement of the first support ring 27b with the second support ring 27a provides both alignment and support for the transmission assembly 22.

The combined transmission assembly 22 and transducer housing 21 b may then be slotted into the nose cone cover 23 to form the nose cone assembly 20.

Referring to Fig 3, there is shown a transmission assembly 32, comprising a control board 39. At substantially the rotational centre of the control board 39 there is mounted a support hub 37c, which is substantially perpendicular to the control board 39. The plurality of electronic circuit boards 38 are fixed to the control board 39, the support hub 37c and are further retained in place by support ring 37a.

In the preferred arrangement the electronic circuit boards are arranged onto the control board 39 with an edge of the electronic circuit boards 38 orientated to face the support hub 37c and the substantial rotational centre of the control board 39. Each of the electronic circuit boards' 38 inner facing edges is engaged with the support hub 37a.

In a preferred embodiment there exists a first support ring 37a around the circumference of the electronic circuit boards 38 outer edges, to provide stability and support. Further to this, support spokes 35 may be arranged in positions between the electronic circuit boards 38 to provide support and rigidity between the transmission assembly 32 and the second surface of the transducer housing (not shown).

In the event of a failure of an electronic circuit board 38, the nose cone assembly may be quickly disassembled, the damaged electronic circuit board 38 removed and a new one slotted in, without removing all the electronic circuit boards. The first support ring 37a, the support hub 37c and the transducer housing (not shown) all provide support for the transmission assembly 32, Further rigidity may be provided when the first support ring 37a is fastened to the second support ring (not shown). Further the support hub 37c may contain a void 31 to allow the passage of a cooling fluid to aid in cooling the electronic circuit boards 38. The cooling may be passive or forced cooling.

The electronic circuit boards 38 may comprise a plurality of pin recesses 32a which provide guidance of the component and rigidity to the connection, further there are a plurality of electrical connection recesses (not shown) in order to facilitate a quick electrical connections between the individual electronic circuit boards 38 of the transmission assembly 32 to the transducer housing and transducer array (not shown).

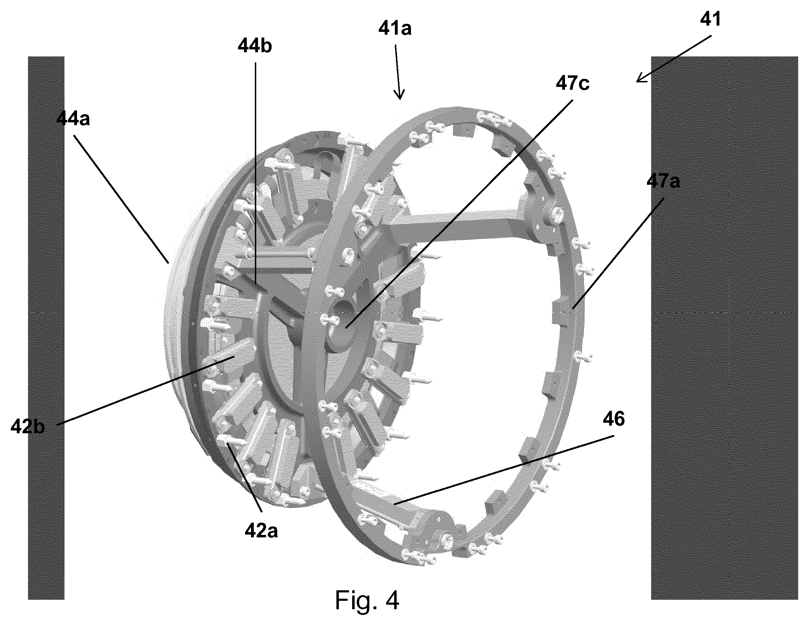

Referring to Fig 4, there is shown the transducer housing 41, with a first surface 44a and a second surface 44b. The sub-frame 41 a comprises a second support ring 47a which is mounted onto the second surface 44b by support legs 46. The second surface 44b, which comprises a number of protrusions 42b for the receipt of the plurality of electrical connection recesses as well as a support hub recess 47c. Further there are a plurality of pins 42a which cooperatively engage with the plurality of pin recesses 32a (shown in Fig 3) present on the electronic circuit boards 28. The pins 42a, support hub recess 47c and recesses 32a enable a more secure connection as well as being a guide to locate the electronic circuit boards 28 on the transducer housing 41. This push-fit connection allows faster assembly/disassembly as required.

## Claims

1. A nose cone assembly for a munition, comprising a transducer array operably linked to a transmission assembly, wherein the transducer array is operably connected to a transducer housing, said transducer housing comprising a first and second surface, wherein said transmission assembly is reversibly operably connected to the second surface of said transducer housing,
said transmission assembly comprising a control board and a plurality of electronic circuit boards, wherein at least one electronic circuit board is a transceiver circuit board,
said electronic circuit boards being reversibly connected to the control board and being arranged along their longest dimension, at an axis substantially perpendicular to the control board and further arranged such that the electronic circuit boards extend radially inwardly to a substantially rotational centre of the control board.

2. A device according to claim 1, wherein a support hub is located at said substantially rotational centre of the control board, and said electronic circuit boards are reversibly engaged with the support hub.

3. A device according to claim 2, wherein the support hub comprises a void to allow the flow of a cooling fluid.

4. A device according to any preceding claim, wherein the electronic circuit boards are each independently operably linked to the second surface of the transducer housing.

5. A device according to any preceding claim, wherein the electronic circuit boards are supported by a first support ring located around the circumference of the electronic circuit boards.

6. A device according to claim 5, wherein at least one support spoke is arranged perpendicularly to the control board for connecting said control board to the first support structure.

7. A device according to any preceding claim, wherein the electronic circuit boards are reversibly engaged with the control board via a push-fit arrangement.

8. A device according to any one of claims 5 to 7, wherein the electronic circuit boards are reversibly engaged with the second surface of the transducer housing via a push-fit arrangement.

9. A device according to claim 7 or 8, wherein the push-fit arrangement comprises a co-operative guide pin and recess arrangement.

10. A device according to any preceding claim, wherein a sub-frame is, mounted on the second surface of the transducer housing, said sub frame comprising a second support ring, wherein the second support ring of the sub-frame engages with the first support ring of the transmission assembly.

11. A device according to claim 10, wherein the sub-frame is mounted on the second surface of the transducer housing by at least one mounting leg.

12. A device substantially as described herein with reference to the accompanying drawings.

13. An electronic circuit board arrangement, comprising a plurality of electronic circuit boards and a control board, wherein the electronic circuit boards are reversibly connected to the control board and are arranged along their longest dimension at an axis substantially perpendicular to the control board and further arranged such that the electronic circuit boards extend radially inwardly to a substantially rotational centre of the control board.
